Europäisches Patentamt

European Patent Office

Office européen des brevets

(19)

(11) Publication number: **0 039 774**

**B1**

(12) **EUROPEAN PATENT SPECIFICATION**

(45) Date of publication of patent specification: **15.08.84**

(21) Application number: **81102497.5**

(22) Date of filing: **02.04.81**

(51) Int. Cl.³: **C 04 B 35/58,**
**C 04 B 41/06,**
**C 23 C 17/00, C 23 C 13/12**

(54) Refractory structure and process for making it.

(30) Priority: **12.05.80 US 148610**

(43) Date of publication of application:
**18.11.81 Bulletin 81/46**

(45) Publication of the grant of the patent:
**15.08.84 Bulletin 84/33**

(84) Designated Contracting States:
**DE FR GB**

(56) References cited:
**DE - A - 2 348 405**
**US - A - 3 949 122**

**Chemical Abstracts, vol. 57, 1962 Columbus,**
**Ohio, USA DREGER et al. "Sublimation and**
**decomposition studies on boron nitride and**
**aluminum nitride" columns 13211i to 13212a**

(73) Proprietor: International Business Machines
Corporation
Old Orchard Road
Armonk, N.Y. 10504 (US)

(72) Inventor: Freeouf, John Lawrence
Susan Drive
Peekskill New York 10566 (US)
Inventor: Haag, William John
30 Caudie Drive
Poughkeepsie New York 12603 (US)
Inventor: Woodall, Jerry McPherson
336 Cherry Street
Bedford Hills New York 10507 (US)

(74) Representative: Barth, Carl Otto
IBM Europäische Patentdienste Rablstrasse 24
D-8000 München 80 (DE)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention concerns a refractory compound structure comprising a substrate of a compound which is a combination of a refractory and/or metallic element and a non-metallic element, and a layer of the refractory and/or metallic element on the substrate. The present invention also concerns a process for formation of the refractory compound structures, particularly the selective formation of the desired layer on predetermined portions of the substrate.

A refractory structure obtained by the present invention is a refractory utensil of, e.g., boron nitride having a surface region of elemental boron thereon. Such refractory utensils are suitable as source boats or crucibles for use under high vacuum conditions, such as in molecular beam epitaxy processing.

Boron nitride crucibles have been used as evaporation source boats under high vacuum conditions. In particular, such show great promise in molecular beam epitaxy processing with materials like gallium. However, the source boats presently available require high current input which necessitates the use of cumbersome electrical supply equipment for resistance heating. Moreover, contamination from the nitrogen present in the boron nitride under certain conditions is very undesirable and can be quite a problem depending upon the particular ingredients being treated in the crucible. For instance, molten gallium can be contaminated with the nitrogen from the boron nitride crucible.

Difficulties have been experienced in attempting to coat and/or bond boron nitride with certain metals. U.S. Patents 3 926 571 and 3 344 505 show examples. In addition, attempts to coat boron onto a substrate have usually involved a gaseous mixture of a boron compound along with a gas, such as hydrogen, as exemplified by U.S. Patents 3 677 799 and 3 949 122.

A boron nitride sample which is heavily coated with boron is mentioned by Dreger et al in the Journal Phys. Chem., Vol. 66, No. 8, 1962, on pages 1556 through 1559. However, the application of a thin, adherent, dense, elemental surface layer is nowhere addressed. In particular, the removal of the developing vapor of the non-metallic element, i.e. the boron, is not mentioned.

DE—A1—2 348 405 shows a method to render a silicion nitride article conductive by heating it. This produces a silicon network under the surface of the article. Any formation of silicon on the surface is unwanted and considered detrimental.

The present invention intends to provide a remedy for these drawbacks. Basically, it concerns a process for forming a refractory compound structure with a thin, dense, adherent, elemental surface layer of a metal or refractory non-metallic element, said compound consisting of a non-metallic element and said metal or refractory non-metallic element, said metal or refractory non-metallic element being solid at room temperature and having a vapor pressure at least one order of magnitude below that of said non-metallic element in the temperature range at which decomposition of the refractory compound occurs, said process including heating said untreated structure to at least said decomposition temperature, characterized by heating said untreated structure in a vacuum of less than 0,133 Pa ($10^{-3}$ Torr) for a time and at a temperature sufficient to form said surface layer to a thickness of about 0.1 to 25 $\mu$m and, during said heating, removing the developing vapor of said non-metallic element.

The significant difference in vapor pressures results in what can be referred to as non-stoichiometric decomposition of the refractory compound. The refractory compound structure has an adherent dense elemental layer of the refractory and/or metallic element of the refractory compound over at least one surface of the structure.

The process includes evacuating a chamber which contains the refractory compound and heating the refractory compound in the chamber at a decomposition temperature for a time sufficient to form the elemental layer of the refractory and/or metallic element component of the refractory compound on the surfaces of the refractory compound.

Embodiments of the invention are described below.

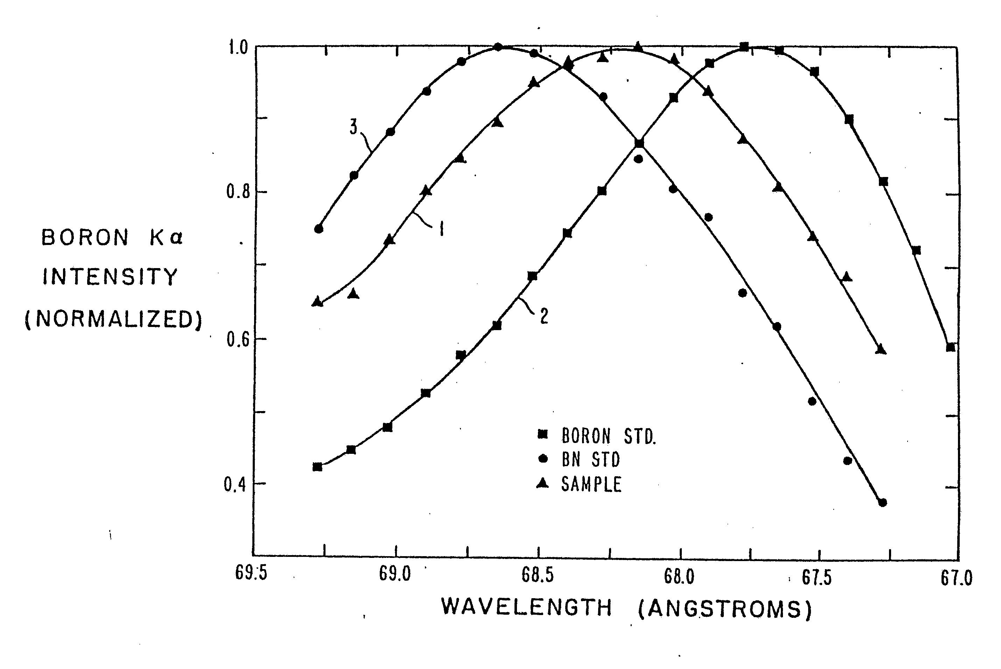

The appended Figure shows data including that obtained by treating a boron nitride article according to the present invention.

The process of the present invention is applicable for treating refractory compound which are combinations of a refractory and/or metallic element and a non-metallic element. The refractory and/or metallic element must be solid at normal room temperatures and must have a vapor pressure of at least one order of magnitude lower than the vapor pressure of the nonmetallic element of the refractory compound in the temperature range at which decomposition of the refractory compound occurs. This difference in vapor pressure is essential to the practice of the present invention, since such makes it possible for the decomposition of the compounds to be non-stoichiometrical whereby the nonmetallic element can be removed from the system, such as by being pumped away under low pressure. In turn, the refractory and/or metallic element of the refractory compound will remain as an elemental layer on the refractory compound.

Examples of suitable refractory compounds are Group III—V compounds and Group II—VI refractory compounds, provided that the refractory and/or metallic element and nonmetallic element of said compounds satisfy the above discussed requirements. Examples of specific compounds which can be treated according to the present invention are aluminum nitride and preferably boron nitride. Mixtures of compounds and/or compounds of mixtures of refractory and/or metallic elements and/or non-metallic elements can be used, if desired.

The process of the present invention results in the formation of a uniform film of the refractory and/or metallic element of the refractory compound. A uniform film does not form in those areas of the refractory compound which are not heated to the decomposition temperature under the conditions and for the times required by the process of the present invention.

The selectivity of the coating of the present invention makes it possible to coat less than an entire surface, and coat only preselected areas for a controlled geometry by appropriate masking of those areas which are not to be subjected to the high decomposition temperatures of the refractory compound. Also, coating of preselected areas can be accomplished by masking areas of the refractory compound with a material which retards decomposition of the refractory compound, such as $Al_2O_3$ or BN and then subjecting the entire surface to the decomposition temperatures. In addition, predetermined controlled geometry for the coating can be obtained by using laser heating and writing of the controlled or predetermined geometry on the surface. This technique is suitable for providing circuits on ceramics, for instance for chip-bonding whereby extremely high resolution is not necessary. Such a process is quite advantageous, since it is planar. In addition, layered structures can be obtained by a subsequent pyrolytic deposition of subsequent layers.

The formation of a uniform elemental layer of the refractory and/or metallic element of the refractory compound is quite surprising in view of the previous experience with the decomposition of, for instance, other Group III—V compounds, such as gallium arsenide. The heating of gallium arsenide in vacuum is known to form droplets and not a uniform film. In fact, such decomposition has been a problem in semiconductive devices employing gallium arsenide.

The structures treated according to the present invention can be any desired type of structure including crucibles or boats which can be used in vacuum evaporation processes in molecular epitaxy processing, such as in the evaporation of gallium.

The process of the present invention is carried out by placing the refractory compound to be treated in a chamber and evacuating the chamber to provide an environment of less than about 0.133 Pa ($10^{-3}$ torr).

These surfaces and/or portions of surfaces of the refractory compound on which it is desired to form the elemental layer are heated while under vacuum to decomposition temperature which for boron nitride is usually from about 1500 to about 1800°C. For boron nitride, the preferred temperature is about 1600°C. For aluminum nitride, the temperature is about 1300 to 1700°C. The heating is carried out for a time sufficient to form the elemental layer of the refractory and/or metallic element on the structure and is usually about 2 to about 20 hours, and preferably from about 5 to about 15 hours.

The temperature and time are inversely related. That is, when employing temperatures near the upper end of the range, the times employed can be nearer the lower end of the range given, and vice versa.

Preferably, the nonmetallic element of the refractory compound in gaseous form is removed or pumped away from the treating zone under low pressure as it is formed in the decomposition of the refractory compound. For instance, when employing boron nitride, atomic nitrogen is preferably pumped away from the treating zone. Typically, coatings of the refractory compound for use as crucible of about 0.1 to about 25 $\mu$m are formed by the present invention.

The following example further illustrates the present invention.

A boron nitride crucible about 38 mm long and about 9.5 mm in diameter with a wall thickness of about 0.5 mm is placed within a chamber which is evacuated to about 0.667mPa ($5 \times 10^{-6}$ torr). The boron nitride crucible is subjected to 1600°C for about 10 hours. The product obtained shows a gray metallic coating of boron of about 10 $\mu$m thick over the entire crucible except for the base of the crucible upon which it was standing in the chamber. The coating is electrically conductive.

Curve 1 in the Figure represents the amount of boron measured in the coating on the crucible. A comparison of curve 1 with curve 2, which is the curve obtained from standard boron, and with curve 3, which is the results obtained from boron nitride, illustrate that the coating is substantially elemental boron.

Curve 1 is somewhat shifted to the left of curve 2 for standard boron in view of the presence of the boron nitride beneath the boron in the sample of the present invention.

In view of the relatively high resistance of the boron refractory layer, it is possible to provide high energy to the boron nitride article coated with the boron at relatively low current levels. On the other hand, source crucibles presently available require high current input which necessitates cumbersome electrical supply equipment for resistance heating.

**Claims**

1. A process of making a refractory compound structure with a thin, dense, adherent, elemental surface layer of a metal or refractory non-metallic element, said compound consisting of a non-metallic element and said metal or refractory non-metallic element, said metal or refractory non-metallic element being solid at room temperature and having a vapor pressure atuleast one order of magnitude below that of said non-metallic element in the temperature range at which decomposition of the refractory compound occurs, said process including heating said untreated structure to at least said decomposition temperature, characterized by heating said untreated structure in a vacuum of less than 0.133 Pa (10⁻³ Torr) for a time and at a temperature sufficient to form said surface layer to a thickness of about 0.1 to 25 $\mu$m and, during said heating, removing the developing vapor of said non-metallic element.

2. The process of claim 1, wherein only preselected areas of said structure surface are heated to said decomposition temperature to form a desired pattern.

3. The process of claim 1, wherein said structure surface is heated selectively by masking the surface areas not to be covered by said elemental pattern with a material which retards decomposition of said compound and subjecting the entire structure to said decomposition temperature.

4. The process of claim 3, wherein said retarding material is aluminum oxide or boron nitride.

5. The process of claim 1, 2 or 3, wherein said structure surface is heated selectively by a laser beam.

6. The process of any of the preceding claims, wherein said refractory compound is selected from Group III—V and Group II—VI compounds.

7. The process of claim 6, wherein said refractory non-metallic element is boron, said refractory compound is boron nitride, and said heating takes place for about 5 to 15 hours at a temperature of about 1500 to 1800°C.

8. The process of claim 7, wherein said heating takes place for about 10 hours at a temperature of about 1600°C and a pressure of about 0.667 mPa (5×10⁻⁶ Torr) to develop an about 10 $\mu$m thick surface layer.

9. The process of claim 6, wherein said metal is aluminum, said refractory compound is aluminum nitride, and said heating takes place for about 5 to 15 hours at about 1300 to 1700°C.

## Revendications

1. Procédé pour la préparation d'une structure de composé réfractaire avec une couche de surface élémentaire, mince, dense, adhérente d'un métal ou d'un élément réfractaire non métallique, le dit composé étant constitué d'un élément non métallique et le dit métal ou élément réfractaire non métallique étant solide à température ambiante et possédant une pression de vapeur au moins un ordre de grandeur en dessous de celle du dit élément non métallique dans l'intervalle de température dans lequel une décomposition du composé réfractaire a lieu, le dit procédé comprenant un chauffage de la dite structure non traitée à, au moins, la dite température de décomposition, caractérisé par un chauffage de la dite structure non traitée sous un vide inférieur à 0.133 Pa (10⁻³ torr) pendant un temps et à une température suffisants pour former la dite couche de surface en une épaisseur d'environ 0.1 à 25 $\mu$m et, durant le dit chauffage, l'enlèvement de la vapeur se formant du dit élément non métallique.

2. Procédé selon la revendication 1, dans lequel seules des zones, présélectionnées de la dite surface de structure sont chauffées à la dite température de décomposition pour former un motif désiré.

3. Procédé selon la revendication 1, dans lequel la dite surface de structure est chauffée sélectivement en masquant les zones de surface ne devant pas être recouvertes par le dit motif élémentaire avec un matériau qui retarde la décomposition du dit composé et en soumettant toute la structure à la dite température de décomposition.

4. Procédé selon la revendications 3, dans lequel le dit matériau retardant est de l'oxyde d'aluminium ou du nitrure de bore.

5. Procédé selon les revendications 1, 2 ou 3, dans lequel la dite surface de structure est chauffée, d'une façon sélective, par un rayon laser.

6. Procédé selon l'une des revendications précédentes, dans lequel le dit composé réfractaire est choisi parmi des composés du Groupe III—V et du Groupe II—VI.

7. Procédé selon la revendication 6, dans lequel le dit élément réfractaire non métallique est du bore, le dit composé réfractaire est du nitrure de bore, et le dit chauffage a lieu pendant environ 5 à 15 heures à une température d'environ 1500 à 1800°C.

8. Procédé selon la revendication 7, dans lequel le dit chauffage a lieu pendant environ 10 heures à une température d'environ 1600°C et une pression d'environ 0.667 mPa (5×10⁻⁶ torr) pour former une couche de surface d'environ 10 $\mu$m d'épaisseur.

9. Procédé selon la revendication 6, dans lequel le dit métal, es de l'aluminium, le dit composé réfractaire est du nitrure d'aluminium, et le dit chauffage a lieu pendant environ 5 à 15 heures à environ 1300 à 1700°C.

## Patentansprüche

1. Verfahren zum Herstellen einer feuerbeständigen Verbindungsstruktur mit einer dünnen, dichten, haftfähigen, elementaren Oberflächenschicht eines Metalls oder eines feuerbeständigen nichtmetallischen Elements, wobei diese Verbindung aus einem nichtmetallischen Element und diesem Metall oder dem feuerbeständigen nichtmetallischen Element besteht, und wobei das Metall oder das feuerbeständige nichtmetallischen Element bei Zimmertemperatur im festen Zustand ist und einen Dampfdruck hat, der mindestens um eine Größenordnung niedriger ist als der des nichtmetallischen Elements innerhalb der Zersetzungs-Temperaturspanne der feuerbeständigen Verbindung, und wobei die unbehandelte Struktur auf mindestens die Zersetzungstemperatur erhitzt wird, gekennzeichnet durch folgende Schritte:

Erhitzen der unbehandelten Struktur in einem Vakuum von weniger als 0.133 Pa ($10^{-3}$ Torr) während einer Zeitspanne und bei einer Temperatur, die zur Bildung der Oberflächenschicht in einer Stärke von ca. 0.1 bis 25 $\mu$m ausreicht, und Entfernen während dieses Erhitzungsvorgangs des sich entwickelnden Dampfes des nichtmetallischen Elements.

2. Verfahren nach Anspruch 1, worin nur vorbestimmte Bereiche der Strukturoberfläche auf die Zersetzungstemperatur zur Bildung eines erwünschten Musters erhitzt werden.

3. Verfahren nach Anspruch 1, in welchem die Strukturoberfläche selektiv erhitzt wird durch Maskieren derjenigen Oberflächenbereiche, die nicht von dem elementaren Muster bedeckt sind, mit einem Material, welches die Zersetzung der Verbindung verzögert, und worin die gesamte Struktur auf die Zersetzungstemperatur erhitzt wird.

4. Verfahren nach Anspruch 3, in welchem das Verzögerungsmaterial Aluminiumoxid oder Bornitrid ist.

5. Verfahren nach den Ansprüchen 1, 2 oder 3, in welchem die Strukturoberfläche selektiv durch einen Laserstrahl erhitzt wird.

6. Verfahren nach einem der vorhergehenden Ansprüche, in welchem die feuerbeständige Verbindung aus Verbendungen der Gruppen III—V and II—VI ausgewählt wird.

7. Verfahren nach Anspruch 6, in welchem das feuerbeständige nichtmetallische Element Bor ist, die feuerbeständige Verbindung Bornitrid, und in welchem während ca. 5 bis 15 Stunden bei einer Temperatur von ca. 1500 bis 1800°C erhitzt wird.

8. Verfahren nach Anspruch 7, in welchem während ungefähr 10 Stunden bei einer Temperatur von ungefähr 1600°C und einem Druck von ungefähr 0.667 mPa ($5 \times 10^{-6}$ Torr) erhitzt wird, um eine ungefähr 10 $\mu$m dicke Oberflächenschicht zu entwickeln.

9. Verfahren nach Anspruch 6, in welchem das Metall Aluminium ist, die feuerbeständige Verbindung Aluminiumnitrid, und bei dem während ungefähr 5 bis 15 Stunden bei ungefähr 1300 bis 1700°C erhitzt wird.

0 039 774